# EUROPÄISCHE PATENTSCHRIFT

(11) **EP 0 632 848 B1**
(45) Veröffentlichungstag und Bekanntmachung des Hinweises auf die Patenterteilung: **17.12.1997**
(21) Anmeldenummer: 93920515.9
(22) Anmeldetag: 17.03.1993
(51) Int. Cl.: C23C 14/02, C23C 16/02, C23C 14/20, C23C 16/06

(54) **VERFAHREN ZUR VORBEHANDLUNG DER OBERFLÄCHEN VON KUNSTSTOFFTEILEN SOWIE EIN NACH DIESEM VERFAHREN VORBEHANDELTES KUNSTSTOFFTEIL**
PROCESS FOR PRETREATING THE SURFACES OF PLASTIC COMPONENTS AND PLASTIC COMPONENT PRETREATED BY THIS PROCESS
PROCEDE DE PRETRAITEMENT DE LA SURFACE DE PIECES EN MATIERE PLASTIQUE ET PIECE EN MATIERE PLASTIQUE PRETRAITEE PAR CE PROCEDE

(30) Priorität: 26.03.1992 DE 4209807; 05.03.1993 DE 4306971
(43) Veröffentlichungstag der Anmeldung: 11.01.1995
(73) Patentinhaber: BAYER AG, 51368 Leverkusen (DE)
(72) Erfinder: THURM, Siegfried, D-4005 Meerbusch 3 (DE); SOMMER, Klaus, D-5060 Bergisch Gladbach 2 (DE); BIER, Peter, D-4150 Krefeld 1 (DE); ELSCHNER, Andreas, D-4330 Mülheim/Ruhr (DE); KOWITZ, Manfred, D-4130 Moers (DE); SANDQUIST, Axel, D-4019 Monheim (DE)
(86) Internationale Anmeldenummer: EP9300630
(87) Internationale Veröffentlichungsnummer: WO9319218

(56) Entgegenhaltungen:
- EP-A- 0 057 374
- FR-A- 2 648 827
- DATABASE WPIL Week 3186, Derwent Publications Ltd., London, GB; AN 86 200991 C31!

## Beschreibung

Gegenstand der vorliegenden Erfindung ist ein Verfahren zur Vorbehandlung der Oberfläche von Kunststoffteilen in einem Niederdruckplasma zum nachfolgenden Aufbringen von Schichten, insbesondere Metallschichten, wobei ein Prozeßgas für das Niederdruckplasma verwendet wird, das Schwefelhexafluorid (SF₆) enthält, dadurch gekennzeichnet, daß dieses Prozeßgas im wesentlichen frei von Sauerstoff gehalten wird, daß die Kunststoffoberfläche beim Vorbehandeln von Fluoranlagerungen bzw. -einlagerungen freigehalten wird durch Einstellung der elektrischen Leistung und Einhaltung einer Prozeßzeit der Vorbehandlung im Niederdruckplasma von 0,5 bis 5 Minuten bei einem Prozeßdruck von 1,0 bis 50 Pascal.

Die Erfindung liegt auf dem technischen Gebiet der Oberflächenbehandlung von Kunststoffen. Für viele Anwendungen solcher Teile ist es wünschenswert, diese an der Oberfläche besonders zu beschichten. Eine der häufigsten Anwendungen ist dabei das Aufbringen von Metallschichten, insbesondere von Aluminiumschichten. Eine besondere Schwierigkeit bei der Durchführung solcher Beschichtungen ist die im allgemeinen geringe Haftung zwischen aufgebrachter Schicht und dem Kunststoffteil. Um diese Haftung zu verbessern, ist es bekannt, die Kunststoffteile einer Plasmabehandlung zu unterziehen.

So ist beispielsweise aus US-A-3 686 018 eine Methode zur Metallisierung eines Kunststoffsubstrates bekannt. Das Kunststoffsubstrat wird zur Verbesserung der Haftung mittels einer Niederdruckgasentladung behandelt, die vorzugsweise Sauerstoff als Prozeßgas enthält. Weiter ist aus US-A-4 756 964 ein Verfahren zur Herstellung von Barriereschichten aus amorphem Kohlenstoff auf Polycarbonat-, Polyethylen- oder Polypropylensubstrat bekannt, bei dem die Kunststoffoberfläche mit einem Gasplasma, das vorzugsweise Argon enthält, behandelt wird. Aus US-A-4 264 750 und US-A-4 404 256 ist ein Verfahren zur Behandlung fluorfreier Polymerer bekannt, bei dem durch Behandlung mit fluorhaltigen Gasen in einem Niedertemperaturplasma die Oberfläche der Polymeren fluoriert wird. Mit diesen bekannten Verfahren, bei welchen das Fluor in die Oberfläche eingelagert wird, konnte eine befriedigende Haftung der nachfolgenden Metallbeschichtung von insbesonders hochtemperaturbeständigem Polycarbonat nicht erzielt werden.

Aus der Offenlegungsschrift JP-A-61133239 entsprechend der Publikation ,,Database WPIL, Week 3186, Derwent Publications Ltd., London; AN 68-200991 C31" ist ein Oberflächenbehandlungsverfahren von Kunststoffen mittels Plasmabehandlung bekannt geworden, bei dem Fluorkohlenwasserstoffe oder Fluorschwefelverbindungen als Prozeßgas, ggf. in Verbindung mit Inertgasen benutzt werden, um in einer dünnen Oberflächenschicht des Polymers Fluor anzulagern und eine Oberfläche mit schwachen Haftungseigenschaften zu erzeugen, die witterungsfest und wasserabweisend ist.

Demgegenüber bestand die Aufgabe, ein Verfahren zur Oberflächenbehandlung von Kunststoffteilen zu finden, mit dem sich die Haftung nachfolgend aufgebrachter Schichten verbessern läßt.

Diese Aufgabe wird dadurch gelöst, daß das Prozeßgas frei von Sauerstoff gehalten wird und daß die Kunststoffoberfläche beim Vorbehandeln von Fluoranlagerungen bzw. -einlagerungen freigehalten wird durch Einstellung der elektrischen Leistung und Einhaltung einer Prozeßzeit der Vorbehandlung im Niederdruckplasma von 0,5 bis 5 Minuten bei einem Prozeßdruck von 1,0 - 50 Pascal.

Niederdruckplasmen und ihre Erzeugung sind seit langem bekannt. Sie sind dadurch charakterisiert, daß der Druck in der Kammer, in der die Plasmabehandlung durchgeführt wird, unterhalb des Atmosphärendruckes liegt. In der Fachwelt wird das Niederdruckplasma häufig auch als Niedertemperaturplasma bezeichnet, da die Kunststoffsubstrate einer Temperatur von maximal bis zu 200°C ausgesetzt werden. Die Niederdruckplasmabehandlung ist gekennzeichnet durch die Größen Prozeßdruck, elektrische Leistung und Prozeßzeit sowie durch das verwendete Prozeßgas. Bekannte Prozeßgase sind beispielsweise Sauerstoff, Luft, Edelgas, Stickstoff oder Tetrafluormethan.

Die Durchführung des neuen Verfahrens erfolgt vorteilhaft in der gleichen Vakuumanlage, in welcher anschließend die Metallschicht aufgebracht wird, die zum Kunststoffteil eine gute Haftung aufweisen soll. Der Prozeßdruck beträgt von 1,0 Pa bis 50 Pa. Bei dem erfindungsgemäßen Verfahren wird als Prozeßgas reines SF₆ mit anderen sauerstofffreien Gasen, bevorzugt von Edelgasen, benutzt.

Der Schwefelhexafluoridanteil beträgt dabei vorzugsweise mindestens 50 %.

Die Anregung des Plasmas geschieht durch ein elektrisches Feld mit Frequenzen bis 10 GHz, wobei der bevorzugte Frequenzbereich zwischen 0 und 30 MHz liegt. Die Prozeßzeit der Vorbehandlung im Niederdruckplasma beträgt 0,5 bis 5 Minuten.

Das Verfahren läßt sich bevorzugt bei Polycarbonat bzw. Blends und Copolymeren dieses Kunststoffs anwenden. Im Vergleich zu den bekannten Verfahren zeigt das neue Verfahren eine besondere Verbesserung für hochtemperaturbeständige Polycarbonate, wie sie beispielsweise aus DE 3 832 396-A1 bekannt sind. Sie basieren auf Dihydroxydiphenylcycloalkanen, wobei die Cycloalkane bevorzugt mit Methylgruppen, insbesondere in der 3- bzw. 3,3-Stellung, substituiert sind.

Nachdem die Kunststoffteile in erfindungsgemäßer Weise vorbehandelt wurden, wird eine Metallschicht, in einem bevorzugten Beispiel aus A1, aufgebracht. Die Schichtdicke beträgt 1 nm bis 100 000 nm, vorzugsweise 10 nm bis 10 000 nm. Verfahren zum Aufbringen von Metallschichten sind literaturbekannt. Es eignen sich Aufdampfen, Sputtern, Ionenplattieren, Plasma-CVD (chemical vapor desposition) usw., die dem Fachmann geläufig sind. Geeignete Kunststoffteile, die nach dem erfindungsgemäßen Verfahren vorbehandelt werden können, sind beispielsweise Platten, Reflektoren für Automobilscheinwerfer sowie Formkörper jeglicher Art und Dimension, z. B. als Gehäuse für Geräte und Folien für Verpackungs- und Dekorationszwecke.

Gegenstand der Erfindung ist auch ein metallisiertes und/oder lackiertes Kunststoffteil mit einer Vorbehandlung entsprechend dem Verfahren nach einem der Ansprüche 1 bis 4, dadurch gekennzeichnet, daß die vorbehandelte Oberfläche frei von Fluor ist und daß die Haftung der aufgebrachten Metall- und/oder Lackschicht einen Klebebandtest mit einer Abzugskraft von 7 N/cm übersteht.

Vorzugsweise besteht das metallisierte und/oder lackierte Kunststoffteil, insbesondere in Form eines Reflektors, aus Polycarbonat, insbesondere aus hochtemperaturbeständigem Polycarbonat auf Basis von Dihydroxydiphenylcycloalkanen.

### Beispiele

Zur beispielhaften Erläuterung der Erfindung wurden folgende Kunststoffe eingesetzt:
- A =: Polycarbonat auf Basis von Bisphenol A
- B =: Polycarbonat auf Basis von hydriertem Isophoron
- C =: Blend aus einem Polycarbonat auf Basis Bisphenol A und Acrylbutadienstyrol.

Die nach dem erfindungsgemäßen Verfahren vorbehandelte Fläche der Proben betrug 11 x 15 cm.

Als Metall, dessen Haftung auf dem Kunststoffteil verbessert werden soll, wurde Aluminium (Al) benutzt. Dieses wurde durch Aufdampfen auf die Kunststoffteile aufgebracht.

Die Prüfung der Haftung der an die Vorbehandlung anschließend aufgebrachten Al-Schichten erfolgte nach dem sogenannten Klebebandtest. Dabei wurden Klebebänder von 20 mm Breite und ca. 80 mm Länge auf die zu untersuchenden Proben aufgebracht.

Zur Haftungsbeurteilung wurden Klebebänder des Herstellers Beiersdorf AG, Hamburg, BRD, mit definierter Abzugskraft benutzt:

| Typ | Abzugskraft (N/cm) |
|---|---|
| 4106 | 5 |
| 4133 | 7 |

Mit diesen Bändern ist eine Differenzierung der Haftfestigkeit der Metallschichten auf den Kunststofformkörpern möglich.

Das Abrißbild der Al-Schicht wurde in vier Abstufungen beurteilt:
- 0 =: kein Abriß der Al-Schicht
- 1 =: punktförmiger Abriß der Al-Schicht
- 2 =: Abriß der Al-Schicht <50 %
- 3 =: Abriß der Al-Schicht ≥50 %

Zur Untersuchung der Wirkung der Plasmabehandlung auf die Kunststoffoberfläche wurde eine erfindungsgemäß behandelte Oberfläche des Kunststoffs B mit Hilfe des ESCA-Verfahrens (Ullmanns Encyclopädie der technischen Chemie, 4. Auflage, Band 5, "Analysen- und Meßverfahren", S. 522, Verlag Chemie Weinheim; Deerfield Beach, Florida, Basel) untersucht, um die Wirkung der Vorbehandlung auf die chemische Zusammensetzung zu bestimmen. Dabei wurde überraschenderweise gefunden, daß durch das erfindungsgemäße Verfahren kein Fluor, wohl aber Schwefel in die Oberfläche des vorher schwefelfreien Polymers eingelagert wird. Die Ergebnisse sind in Tabelle 2 dargestellt. Es sei angemerkt, daß Wasserstoff mit dem ESCA-Verfahren nicht nachgewiesen werden kann.

### Beispiel 1

Die eingangs erwähnten Probentypen A, B und C wurden in einer Ausdampfanlage A 600 der Fa. Leybold Heraeus, Hanau, BRD, auf einem rotierbaren Substrathalter befestigt. Anschließend wurde die Prozeßkammer der Aufdampfanlage geschlossen und auf ca. 0,01 Pa evakuiert. Danach wurde SF₆ bis zu einem Druck von 7 Pa eingelassen. Die Druckmessung erfolgte mit einem gasartunabhängigen Kapazitätsmanometer. Anschließend wurde der Drehantrieb des Substrathalters eingeschaltet, so daß dieser mit 20 U/min rotierte. Durch Anlegen einer Spannung von -475 V gegen Erde an eine als Kathode geschaltete Al-Platte wurde ein Niederdruckplasma gezündet. In diesem Plasma wurden die Proben 2 Minuten mit einer Leistung von 3,8 Watt behandelt. Danach wurde die Spannung abgeschaltet, die SF₆-Zugabe beendet und die Prozeßkammer auf 0,01 Pa evakuiert.

Nach Erreichen dieses Druckes wurde die Elektronenstrahlkanone eingeschaltet und das zu verdampfende Aluminium, welches sich in einem Graphittiegel befand, mit einer Leistung von 2 kW innerhalb von 180 sec auf ca. 1500 K erhitzt. Anschließend wurde eine bewegliche Blende zwischen Elektronenstrahlkanone und Substrathalter entfernt und die Formkörper für 80 sec bei einer Rate von 1 nm/s beschichtet. Danach wurde die Blende wieder zwischen Elektronenstrahlkanone und Substrathalter eingebracht und der Beschichtungsvorgang beendet. Nach dem Abschalten der Elektronenstrahlkanone und Abkühlung des Verdampfungsgutes wurde nach ca. 10 Minuten die Prozeßkammer belüftet und die beschichteten Kunststoffteile entnommen. Die Prüfung der Haftung der Metallschicht wurde nach dem oben erwähnten Verfahren durchgeführt. Das Ergebnis ist in der am Ende der Beispiele angeführten Tabelle 1 dargestellt. Man sieht, daß die Metallschichten von allen untersuchten Kunststoffen nicht abgelöst werden konnten, d.h. sie weisen eine gute Haftung auf.

### Beispiel 2 (Vergleichsbeispiel)

Kunsttoffteile wie in Beispiel 1 wurden in einem Niederdruckplasma vorbehandelt. Als Prozeßgas wurde Ar benutzt. Alle anderen Prozeßparameter blieben gleich. Die Aufbringung der Al-Schicht und die Prüfung der Haftung geschah wie in Beispiel 1 beschrieben. Die Ergebnisse sind in der Tabelle 1 angegeben. Es zeigt sich, daß bei Klebeband 4106, welches eine Abzugskraft von 5 N/cm aufweist, die Schichthaftung bei Probe A sehr gut, bei den Proben B und C ausreichend ist. Bei der Prüfung mit dem Klebeband 4133, welches eine Abzugskraft von 7 N/cm besitzt, wird dagegen, verglichen mit den Werten aus Beispiel 1, eine deutlich schlechtere Haftung der Metallschicht festgestellt.

### Beispiel 3 (Vergleichsbeispiel)

Kunststoffteile wie in Beispiel 1 wurden in einem Niederdruckplasma vorbehandelt. Als Prozeßgas wurde CF₄ benutzt, wobei Fluor in der Oberfläche angelagert wurde.

Alle anderen Prozeßparameter blieben gleich. Die Aufbringung der Al-Schicht und die Prüfung der Haftung geschahen wie in Beispiel 1 beschrieben; die Ergebnisse sind in der Tabelle 1 angegeben. Es zeigt sich, daß die Al-Schicht eine ungenügende Haftung aufweist.

### Beispiel 4 (Vergleichsbeispiel)

Kunststoffteile wie in den vorherigen Beispielen wurden ohne Vorbehandlung in einem Niederdruckplasma direkt mit Al bedampft und die Haftung der Al-Schicht geprüft. Die Ergebnisse sind in der nachfolgenden Tabelle 1 zusammengefaßt und zeigen, daß die Al-Schichten bei Verwendung beider Klebebänder eine ungenügende Haftung aufweisen.

**Tabelle 1**

| | | Haftung | | | | | |
|---|---|---|---|---|---|---|---|
| Beispiel | Prozeßgas | Klebeband 4106 Probe | | | Klebeband 4133 Probe | | |
| | | A | B | C | A | B | C |
| 1 | SF₆ | 0 | 0 | 0 | 0 | 0 | 0 |
| 2 | Ar | 0 | 2 | 2 | 2 | 3 | 3 |
| 3 | CF₄ | 3 | 3 | 3 | 3 | 3 | 3 |
| 4 | - | 2 | 3 | 2 | 3 | 3 | 3 |

**Tabelle 2**

| Beispiel | Prozeßgas | Bestandteile (at-%) | | | |
|---|---|---|---|---|---|
| | | C | O | F | S |
| 1 | SF₆ | 81 | 18 | 0 | 1 |
| 2 | Ar | 81 | 19 | 0 | 0 |
| 3 | CF₄ | 80 | 17 | 3 | 0 |
| 4 | - | 86,5 | 13,5 | 0 | 0 |

## Patentansprüche

1. Verfahren zur Vorbehandlung der Oberfläche von Kunststoffteilen in einem Niederdruckplasma zum nachfolgenden Aufbringen von Schichten, insbesondere Metallschichten, wobei ein Prozeßgas für das Niederdruckplasma verwendet wird, das Schwefelhexafluorid (SF₆) enthält, dadurch gekennzeichnet, daß dieses Prozeßgas im wesentlichen frei von Sauerstoff gehalten wird, daß die Kunststoffoberfläche beim Vorbehandeln von Fluoranlagerungen bzw. -einlagerungen freigehalten wird durch Einstellung der elektrischen Leistung und Einhaltung einer Prozeßzeit der Vorbehandlung im Niederdruckplasma von 0,5 bis 5 Minuten bei einem Prozeßdruck von 1,0 - 50 Pascal.

2. Verfahren nach Anspruch 1, dadurch gekennzeichnet, daß ein Prozeßgas mit einem Schwefelhexafluoridanteil von mindestens 50 % verwendet wird.

3. Verfahren nach Anspruch 1 oder 2, dadurch gekennzeichnet, daß das Prozeßgas außer SF₆ andere sauerstofffreie Gase, insbesondere Edelgase, enthält.

4. Metallisiertes und/oder lackiertes Kunststoffteil mit einer Vorbehandlung entsprechend dem Verfahren nach einem der Ansprüche 1 bis 3, dadurch gekennzeichnet, daß die vorbehandelte Oberfläche frei von Fluor ist und daß die Haftung der aufgebrachten Metall- und/oder Lackschicht einen Klebebandtest mit einer Abzugskraft von 7 N/cm übersteht.

5. Metallisiertes und/oder lackiertes Kunststoffteil, insbesondere Reflektor, nach Anspruch 4, dadurch gekennzeichnet, daß es aus Polycarbonat, insbesondere aus hochtemperaturbeständigem Polycarbonat auf Basis von Dihydroxydiphenylcycloalkanen, besteht.

## Claims

1. A process for pretreating the surface of plastics components in a low-pressure plasma, for the subsequent deposition of films, particularly metal films, wherein a process gas which contains sulphur hexafluoride (SF₆) is used for the low-pressure plasma, characterised in that this process gas is kept substantially free from oxygen, that the plastics surface is kept free from fluorine deposits or infiltrations during pretreatment by adjusting the electrical power and maintaining a processing time of the pretreatment in the low-pressure plasma from 0.5 to 5 minutes at a processing pressure of 1.0 - 50 pascals.

2. A process according to claim 1, characterised in that a process gas with a sulphur hexafluoride content of at least 50 % is used.

3. A process according to claim 1 or 2, characterised in that in addition to SF₆ the process gas contains other gases which are free from oxygen, particularly inert gases.

4. A metallised and/or lacquered plastics component having a pretreatment corresponding to the process according to any one of claims 1 to 3, characterised in that the pretreated surface is free from fluorine and that the adhesion of the deposited metal and/or lacquer film withstands an adhesive tape test comprising a pull-off force of 7 N/cm.

5. A metallised and/or lacquered plastic component, particularly a reflector, according to claim 4, characterised in that it consists of polycarbonate, particularly of polycarbonate with high temperature stability which is based on dihydroxydiphenylcycloalkanes.

## Revendications

1. Procédé pour le traitement préalable de la surface de pièces de matières plastiques dans un plasma à basse pression en vue d'une application subséquente de couches, en particulier de couches métalliques, dans lequel on utilise pour le plasma à basse pression un gaz opératoire contenant de l'hexafluorure de soufre (SF₆), ce procédé se caractérisant en ce que le gaz opératoire est maintenu essentiellement exempt d'oxygène et en ce que les pièces de matières plastiques sont protégées lors du traitement préalable contre les dépôts et les occlusions de fluor par réglage de la puissance électrique et maintien d'une durée opératoire de 0,5 à 5 min sous une pression de 1,0 à 50 Pa lors du traitement préalable dans le plasma à basse pression.

2. Procédé selon revendication 1, caractérisé en ce que l'on utilise un gaz opératoire dont la teneur en hexafluorure de soufre est d'au moins 50 %.

3. Procédé selon revendication 1 ou 2, caractérisé en ce que le gaz opératoire, en plus de SF₆, contient d'autres gaz exempts d'oxygène, en particulier des gaz rares.

4. Pièce de matière plastique métallisée et/ou peinte après un traitement par le procédé selon l'une des revendications 1 à 3, caractérisée en ce que la surface qui a subi le traitement préalable est exempte de fluor et en ce que l'adhérence de la couche de métal et/ou de peinture appliquée résiste à l'essai à la bande adhésive à force d'arrachement de 7 N/cm.

5. Pièce de matière plastique métallisée et/ou peinte, en particulier réflecteur, selon revendication 4, caractérisée en ce qu'elle consiste en polycarbonate, en particulier polycarbonate résistant aux fortes températures, à base de dihydroxydiphénylcycloalcanes.
